# EUROPÄISCHE PATENTSCHRIFT

(11) **EP 2 765 392 B1**
(45) Veröffentlichungstag und Bekanntmachung des Hinweises auf die Patenterteilung: **02.09.2015**
(21) Anmeldenummer: 13154230.0
(22) Anmeldetag: 06.02.2013
(51) Int. Cl.: G01D 5/244

(54) **Verfahren und Auswerteeinrichtung für eine Plausibilitätsprüfung eines Inkrementalzählers**
Method and evaluation device for a plausibility check of an incremental meter
Procédé et dispositif d'évaluation pour un contrôle de vraisemblance d'un compteur incrémental

(43) Veröffentlichungstag der Anmeldung: 13.08.2014
(73) Patentinhaber: Siemens Aktiengesellschaft, 80333 München (DE)
(72) Erfinder: Wallner, Lorenz, 90766 Fürth (DE)

(56) Entgegenhaltungen:
- DE-A1- 10 240 834
- DE-A1- 19 860 378

## Beschreibung

Die Erfindung betrifft ein Verfahren für eine Plausibilitätsprüfung eines Inkrementalzählers gemäß dem Oberbegriff des Patentanspruchs 1, und eine Auswerteeinrichtung für eine Plausibilitätsprüfung eines Inkrementalzählers gemäß dem Oberbegriff des Patentanspruchs 8.

Zur Erfassung von digitalen Impulsen werden in der Mess-, Steuer- und Regelungstechnik Inkrementalzähler eingesetzt. In einem einfachen Fall bestehen diese aus einem mechanischen oder elektronischen Zählwerk, wobei zumeist Rechtecksignale hinsichtlich steigender oder fallender Flanken oder sog. "Nulldurchgänge" erfasst werden. Ein wichtiger Anwendungsfall besteht in der Positions- oder Bewegungserfassung von Maschinen, beispielsweise Elektromotoren oder angetriebene Achsen von Werkzeugmaschinen oder dgl. Dabei ist es oft üblich, ein sog. "Quadratursignal" zu erfassen, womit auch eine Bewegungsrichtung erfasst werden kann, so dass nach einmaligem Passieren eines Indexschalters oder einmaligem Anfahren einer sog. "Nullstellung" ein Zählerstand des Inkrementalzählers stets Auskunft über die absolute Position eines beobachteten Gegenstandes oder die Lage eines überwachten Rotors oder dgl. gibt. Aus dem zeitlichen Bezug zwischen aufeinanderfolgenden Zählimpulsen kann auch eine Taktrate bzw. eine Bewegungsgeschwindigkeit, Winkelgeschwindigkeit, Drehzahl oder dgl. eines beobachteten mechanischen Systems bestimmt werden.

Wenn es zu elektrischen Störungen ("Störimpulse") auf einer Signalleitung, mit der die Zählimpulse einer Auswerteelektronik oder Auswerteschaltung zugeführt werden, kommt, könnte die Auswerteelektronik diese Störungen fälschlicher Weise auch als Zählsignale interpretieren, wodurch der Zählerstand des Inkrementalzählers ("Positionswert") verfälscht würde und überdies auch die Taktrate bzw. die Geschwindigkeit des beobachteten mechanischen Systems fehlerhaft festgestellt würde. Entsprechendes gilt, wenn aufgrund einer Unterbrechung oder einer anderen Störung ein tatsächlich ausgelöster Zählimpuls nicht von dem Inkrementalzähler erfasst wird, wodurch ebenfalls eine inkorrekte Positionsangabe und ggf. auch eine inkorrekte Taktrate bzw. Geschwindigkeit eines beobachteten mechanischen Systems festgestellt oder gemessen wird.

Die Auswertelogik für Inkrementalencoder, also die Inkrementalzähler aus dem Stand der Technik, verfügen typischer Weise über Filter, welche üblicher Weise nur Zählsignale unterhalb einer bestimmten Frequenz passieren lassen, womit sich dann automatisch auch eine maximale Zählfrequenz bzw. Taktrate oder Geschwindigkeit ergibt. Solche Filter können beispielsweise analog durch ein entsprechend dimensioniertes RC-Glied in der Signalleitung realisiert sein, oder aber auch als digitales Filter, beispielsweise implementiert in einem digitalen Regler. Bei sehr schnellen Zählsignalen, bei einer sehr gestörten Umgebung oder bei der Verwendung von ungeschirmten Signalkabeln kann es aber vorkommen, dass eine reine Filterung anhand der Signalfrequenz nicht ausreicht. Ebenso können irrtümlicher Weise unterdrückte Zählimpulse, beispielsweise durch kurzzeitige Unterbrechungen der Signalleitung, damit nicht aufgefunden oder unterdrückt werden, weil verloren gegangene Zählimpulse zu einer Verringerung der Signalfrequenz führen. Das beschriebene RC-Glied oder ein entsprechendes digitales Filter stellt jedoch einen Tiefpaßfilter dar, der also nicht in der Lage ist, eine solche Störung festzustellen bzw. auszufiltern. Daneben ist es in Applikationen, beispielsweise in der Bewegungssteuerung, die in speicherprogrammierbaren Steuerungen programmiert sind, möglich, eine Plausibilitätsprüfung der erfassten Geschwindigkeit in Positioniersystemen durchzuführen, also beispielsweise prüfen, ob eine festgelegte Maximalgeschwindigkeit oder maximale Taktrate überschritten wurde. Diese Plausibilitätsprüfung wird typischer Weise im Regeltakt der speicherprogrammierbaren Steuerung ausgeführt, also einmal in jedem Zyklus der Steuerung.

Bei den üblichen Zykluszeiten von speicherprogrammierbaren Steuerungen, beispielsweise einer Millisekunde, und den üblichen Verfahrgeschwindigkeiten mechanischer Achsen mit einer entsprechenden Auflösung der Signalaufnehmer bedeutet dies jedoch, dass sich der Zählerstand der Inkrementalzähler von Zyklus zu Zyklus erheblich verändern kann, dass also zwischen zwei Zyklen eine Vielzahl von Zählimpulsen erfasst wird. Daher ist es nicht möglich, einzelne irrtümlicher Weise als Zählimpulse interpretierte Störimpulse zu erkennen, sofern der Anteil der Störimpulse an der Summe der erfassten Zählimpulse vergleichsweise gering ist. Ebenso können sporadische Unterbrechungen, die zwischen zwei Regelungszyklen nur einen vergleichsweise geringen Anteil der tatsächlichen Signalimpulse unterdrücken, ebenfalls nicht mit dieser Methode festgestellt werden.

Es ist daher eine Aufgabe der vorliegenden Erfindung, die mit einem Inkrementalzähler erfassten Zählimpulse genauer zu untersuchen. Außerdem sollen Störungen, die zur Unterdrückung von Zählimpulsen führen, erfasst werden.

Es ist ein zentraler Gedanke der erfindungsgemäßen Lösung dieser Aufgabe, jeden einzelnen erfassten Zählimpuls dahingehend zu überprüfen, ob der Zeitpunkt der Erfassung dieses Zählimpulses hinsichtlich der dynamischen Eigenschaften des beobachteten mechanischen Systems überhaupt plausibel bzw. möglich ist, oder nicht. Dies bedeutet, dass für jeden Zählimpuls überprüft wird, ob mit der bislang festgestellten Geschwindigkeit und einer möglichen Beschleunigung des beobachteten Systems der "realen Welt" überhaupt von dem mechanischen System der neue Zählerstand hätte erreicht werden können, oder nicht. Eine solche Prüfung kann einer speicherprogrammierbaren Steuerung oder einem anderen Mikroprozessorsystem vorgeschaltet werden, also in der Signalaufbereitung selbst vorgenommen werden. Beispielsweise kann eine solche Plausibilitätsprüfung durch einen programmierbaren Logikbaustein (z.B. FPGA - Field Programmable Gate Array) durchgeführt werden, wobei lediglich als Betriebsgrenzen des beobachteten dynamischen Systems die maximal damit mögliche Beschleunigung/Verzögerung und ggf. maximale und minimale Geschwindigkeiten vorgegeben werden müssen. Sofern Zählimpulse detektiert werden, deren Auswertung eine solche maximale Beschleunigung/Verzögerung oder maximale Geschwindigkeit des mechanischen Systems beschreiben, die das reale mechanische System überhaupt nicht leisten kann, kann von einem Fehler ausgegangen werden. Selbiges gilt auch für irrtümlicher Weise ausbleibende Zählimpulse, die ebenfalls auf eine solche Verzögerung (negative Beschleunigung) schließen lassen können, die das reale System ebenfalls aufgrund einer bewegten Masse und beschränkter Bremsleistungen oder dgl. überhaupt nicht aufweisen kann oder darf.

Die Aufgabe wird insbesondere durch ein Verfahren gemäß dem Patentanspruch 1 und durch eine Auswerteeinrichtung nach Patentanspruch 8 gelöst.

Dabei wird ein Verfahren für eine Plausibilitätsprüfung eines Inkrementalzählers vorgeschlagen, wobei mittels des Inkrementalzählers Zählimpulse erfassbar sind, und wobei durch ein dynamisches System die Zählimpulse mit einer zu einem Zustand des dynamischen Systems korrespondierenden Taktrate erzeugt werden. Dabei wird anhand von Betriebsgrenzen des dynamischen Systems ein Minimal- und ein Maximalwert für eine mögliche oder erlaubte Änderung der Taktrate pro Zeiteinheit vorgegeben, wobei in einem ersten Schritt aus den zwei zuletzt erfassten Zählimpulsen jeweils eine aktuelle Taktrate errechnet wird, und wobei in einem zweiten Schritt bei jedem neu erfassten Zählimpuls dieser dahingehend überprüft wird, ob der Unterschied zwischen der im Zuge des neu erfassten Zählimpulses errechneten Taktrate und einer unmittelbar zuvor errechneten Taktrate innerhalb der durch den Minimal- und Maximalwert definierten Grenzen liegt, wobei anderenfalls eine Unplausibilität erkannt wird. Durch dieses Verfahren ist es möglich, die Zählimpulse einzeln dahingehend zu überprüfen, ob sie hinsichtlich der dynamischen Möglichkeiten eines beobachteten mechanischen Systems plausibel sind, oder nicht.

Die Aufgabe wird außerdem durch eine Auswerteeinrichtung für eine Plausibilitätsprüfung eines Inkrementalzählers gelöst, wobei mittels des Inkrementalzählers Zählimpulse erfassbar sind, wobei durch ein dynamisches System die Zählimpulse mit einer zu einem Zustand des dynamischen Systems korrespondierenden Taktrate erzeugt werden. Dabei wird anhand von Betriebsgrenzen des dynamischen Systems ein Minimal- und ein Maximalwert für eine mögliche oder erlaubte Änderung der Taktrate pro Zeiteinheit vorgegeben, wobei die Auswerteeinrichtung derart eingerichtet ist, dass in einem ersten Schritt aus den zwei jeweils zuletzt erfassten Zählimpulsen jeweils eine aktuelle Taktrate errechnet wird, und wobei in einem zweiten Schritt bei jedem neu erfassten Zählimpuls dieser dahingehend überprüft wird, ob der Unterschied zwischen der im Zuge des neu erfassten Zählimpulses errechneten Taktrate und einer unmittelbar zuvor errechneten Taktrate innerhalb der durch den Minimal- und Maximalwert definierten Grenzen liegt, wobei anderenfalls eine Unplausibilität erkannt wird. Durch eine solche Auswerteeinrichtung können die für das Verfahren angegebenen Vorteile realisiert werden.

Vorteilhafte Ausgestaltungen der Erfindung sind in den abhängigen Patentansprüchen angegeben. Die dabei beschriebenen Merkmale und Vorteile können sowohl einzeln, als auch in Kombination miteinander angewendet werden.

Die Aufgabe wird in der Praxis vorteilhaft durch ein zyklisch wiederholtes Berechnungsverfahren gelöst, wobei in jedem Zyklus Werte für die minimale und maximale Änderungsrate (Geschwindigkeit) als auch für einen minimalen und maximalen möglichen Zählerstand (Position) des Inkrementalzählers aktualisiert werden, wodurch sich ein linearer Verlauf der Werte für die minimal bzw. maximal mögliche Geschwindigkeit und ein quadratischer bzw. parabolischer Verlauf der Werte für den minimal bzw. maximal möglichen Zählerstand (Position) bei konstanter minimaler bzw. maximaler Beschleunigung (bzw. Verzögerung) ergibt. Nach Eingang eines neuen Zählimpulses können die Werte für den möglichen Zählerstand und die Werte für die mögliche Geschwindigkeit auf die aktuellen Ist-Werte für Geschwindigkeit und die Position zurückgesetzt werden. Der beschriebene lineare bzw. parabolische Verlauf gilt also abschnittsweise während derjenigen Zyklen, in denen kein neuer Zählimpuls registriert wird.

Eine vorteilhaft auch in einem FPGA realisierbare Ausführungsform ist also gegeben, indem in dem ersten Schritt im Falle eines neu erfassten Zählimpulses ein Zeitstempel erfasst wird, wobei aus der Differenz der Zeitstempel der beiden zuletzt erfassten Zählimpulse ein Wert für die aktuelle Taktrate errechnet wird, und in dem zweiten Schritt aus dem aktuellen Zählerstand des Inkrementalzählers, aus der Differenz zwischen einer aktuellen Zeit und dem zuletzt erfassten Zeitstempel, aus dem ermittelten Wert für die Taktrate, und aus dem Minimal- und Maximalwert für die mögliche oder erlaubte Änderung der Taktrate pro Zeiteinheit ein Wertebereich für einen bezogen auf die jeweils aktuelle Zeit jeweils erlaubten aktuellen Zählerstand aktualisiert wird, wonach der jeweils aktuelle Zählerstand mit dem Wertebereich verglichen wird, wobei in dem Falle, in dem der jeweils aktuelle Zählerstand nicht in dem Wertebereich liegt, eine Unplausibilität festgestellt und/oder gemeldet wird. Die damit gegebene Ausführungsform des Verfahrens kann wiederholt in einem einzigen FPGA-Zyklus abgearbeitet werden, wobei die zumeist verwendeten Rechenoperationen, nämlich die Aktualisierung der Werte für den jeweils erlaubten Zählerstand und die durch die Integration der erlaubten Beschleunigung sich ergebende maximal mögliche Geschwindigkeit, durch reine Additions-Operationen ausgeführt werden können, welche in FPGA's und anderen prozessorähnlichen Bausteinen leicht realisierbar sind. Die notwendigen Divisionsoperationen (Kehrwertbildung) zur Ermittlung einer Taktrate bzw. Geschwindigkeit können vorteilhaft durch Aufrufe in einer Wertetabelle realisiert werden, wobei ggf. zwischen benachbarten Tabellenwerten interpoliert werden kann. Beispielsweise können in einer besonders vorteilhaften Ausgestaltung die Kehrwerte von Zweierpotenzen, also von einzelnen Bits eines Byte-Wertes oder eines Datenwortes, aus einer Tabelle ausgelesen werden, wodurch die Ausführung einer echten Divisions-Operation zur Laufzeit vermieden werden kann. Besonders vorteilhaft kann das Verfahren in einem Logikbaustein implementiert werden, indem für die Taktrate, die aktuelle Geschwindigkeit und den bezogen auf die aktuelle Zeit jeweils erlaubten aktuellen Zählerstand Festkommavariablen verwendet werden.

In einer weiteren vorteilhaften Ausgestaltung werden nicht nur Minimal- und Maximalwerte für die mögliche bzw. erlaubte Beschleunigung des mechanischen Systems bzw. der daraus resultierenden Taktrate vorgegeben, sondern auch Grenzen für die maximale bzw. minimale Geschwindigkeit bzw. der daraus resultierenden maximalen bzw. minimalen möglichen oder erlaubten Taktrate. Weiterhin ist es in einer weiteren vorteilhaften Ausgestaltung möglich, eine Prüfung dritter Ordnung ("Ruckprüfung") vorzunehmen, was jedoch bedingt, dass die Auswerteeinrichtung genügend Rechenleistung aufweist, um dies in einem entsprechend kurzen Arbeitszyklus bewältigen zu können. Außerdem würde dies voraussetzen, dass entsprechende Grenzwerte festgelegt werden, also Aussagen über die erwartete Stetigkeit des erfassten Signals getroffen werden können.

In einer vorteilhaften Ausgestaltung werden mit jedem als gültig erfassten Zählimpuls die Inhalte der Variablen, insbesondere der Variablen für die aktuelle Taktrate, den erlaubten Zählerstand und vorteilhaft auch für die maximal und minimal mögliche Taktrate/Geschwindigkeit, zurückgesetzt, wodurch die bei der Integration zwangsläufig von der Realität abweichenden numerischen Werte wieder "eingefangen" werden können.

Als Zeitbasis für die Errechnung der Taktrate/Geschwindigkeit kann vorteilhaft ein Zyklenzähler verwendet werden, der mit jedem Durchlauf des Verfahrens bzw. jedem Arbeitszyklus eines FPGA oder einer anderen Auswerteeinrichtung entsprechend inkrementiert wird. Dadurch kann auf das Vorsehen bzw. auf die Abfrage eines externen Zeitbausteins verzichtet werden. Vorteilhaft wird das Verfahren auch mit einer Überprüfung des "Vergleichsfensters" ausgestattet, womit sichergestellt wird, dass das System nicht in einen Zustand kommt, bei dem eine Änderung der Geschwindigkeit prinzipiell nur durch einen als unplausibel interpretierten Zählimpuls möglich ist. Prinzipiell muss die Zyklusgeschwindigkeit des Überprüfungsalgorithmus immer höher sein als die höchste erwartete Signalfrequenz bzw. als die höchste erwartete Taktrate der Zählimpulse. Umso höher die Zyklusgeschwindigkeit des Überprüfungsalgorithmus und umso mehr Nachkommastellen bei den im Algorithmus genutzten Variablen vorhanden sind, umso genauer kann die Plausibilitätsprüfung durchgeführt werden.

Ein Ausführungsbeispiel des erfindungsgemäßen Verfahrens wird nachfolgend anhand der Zeichnungen erläutert. Es dient gleichzeitig als Ausführungsbeispiel für eine erfindungsgemäße Auswerteeinrichtung.

Dabei zeigen:
- Figur 1: ein vereinfachtes Ablaufdiagramm für das Verfahren, und
- Figur 2: eine vereinfachte Darstellung von Register- und Variableninhalten bei einer Anzahl von Zyklen des erfindungsgemäßen Verfahrens.

Im Folgenden wird der Einfachheit halber das Verfahren nur in einer vereinfachten Version mit nur einer Zählrichtung vorgestellt; eine Erweiterung auf ein Zählen "in beide Richtungen" ist in naheliegender Weise möglich; benötigt wird allerdings ein Quadratursignal oder ein anderes Signal, aus dem hervorgeht, ob ein eingehender Zählimpuls zum Inkrementieren oder zum Dekrementieren des Inkrementalzählers führen soll.

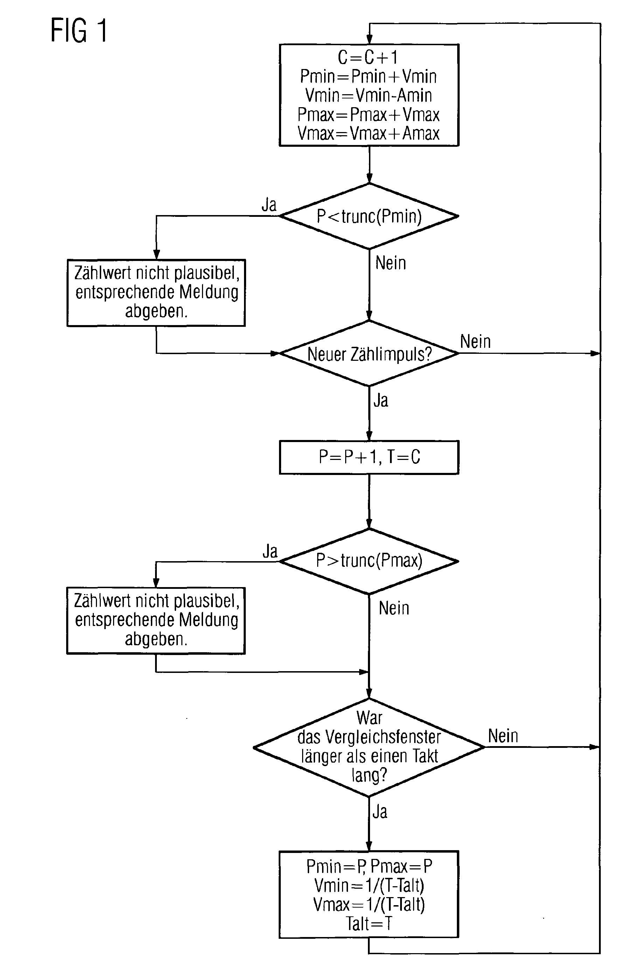

In der Figur 1 ist ein vereinfachtes Ablaufdiagramm des Verfahrens angegeben, wobei in der Praxis vorgesehen ist, das Verfahren und damit das Ablaufdiagramm zyklisch wiederholt durchzuführen. In der Figur 1 hat die Variable C die Bedeutung einer Systemuhr, stellt also einen Taktzähler dar, der mit jedem Durchlauf des Verfahrens und mit jedem Abarbeiten des Ablaufdiagramms inkrementiert wird (oberste Anweisung in der Figur 1). Die Variable P stellt den aktuellen Zählerwert des Inkrementalzählers dar. Die Variable T dient als Zeitstempel des letzten eingegangenen Zählimpulses; damit enthält die Variable T den gleichen Wert, den die Variable C in demjenigen Zyklus aufgewiesen hat, in dem der Zählerwert P zuletzt Inkrementiert wurde. Die Variable Tₐₗₜ enthält den Stempel des vorletzten Zählimpulses (siehe Anweisung im untersten Block des Diagramms in der Figur 1). Die vorgenannten Variablen haben keine Nachkommastellen, stellen also ganzzahlige Zahlen dar.

Weiter werden in dem Diagramm der Figur 1 auch Variablen mit Nachkommastellen verwendet, wobei in einer vorteilhaften Ausgestaltung dieses Ausführungsbeispiels Festkommavariablen verwendet werden. Dabei bezeichnet die Variable Pₘᵢₙ einen Integrations-Akkumulator des Zählerwerks, welcher die Begrenzung der erlaubten Werte nach "unten" (Mindest-Zählerstand) angibt. Der Wert für Pₘᵢₙ verändert sich also mit jedem Zyklus um die im jeweiligen Zyklus minimal mögliche (erlaubte) Geschwindigkeit. Diese ist in der Variablen Vₘᵢₙ angegeben, und ebenfalls als "Integrations-Akkumulator" aufgebaut. Mit jedem Zyklus ändert sich der Inhalt dieser Variablen um die minimal mögliche Beschleunigung, die in der Konstanten Amin vom Nutzer, abhängig von den dynamischen Eigenschaften eines zugrunde gelegten mechanischen Systems, vorgegeben wird. Analog zu Pₘᵢₙ, Vₘᵢₙ und Amin enthalten die Festkommavariablen Pₘₐₓ, Vₘₐₓ und Aₘₐₓ die jeweilige maximalen Werte für den erlaubten Zählerstand, die maximal (theoretisch) mögliche Geschwindigkeit (Taktrate) und die vorgegebene maximal erlaubte Beschleunigung (Änderungsrate der Taktrate).

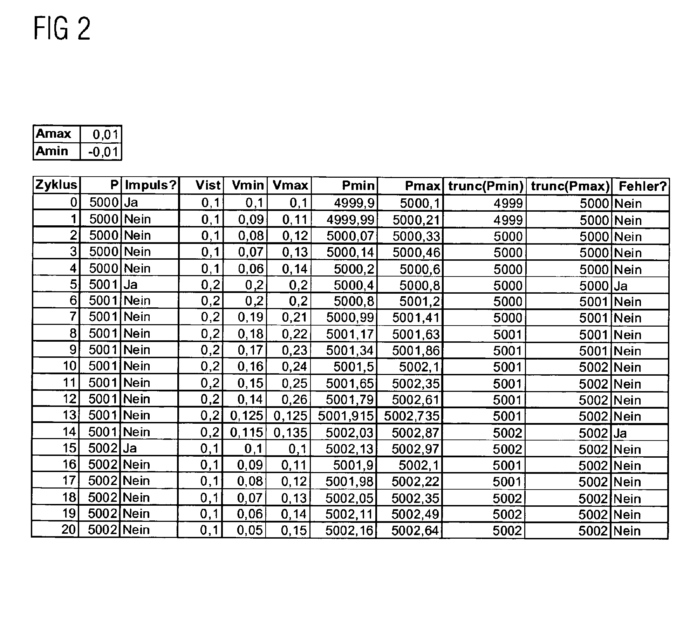

In einem ersten Schritt des Ablaufdiagramms wird zunächst, wie bereits erwähnt, die Systemuhr (Variable C) inkrementiert, wonach die jetzt aktuellen, neuen Inhalte der Variablen Pₘᵢₙ, Vₘᵢₙ, Pₘₐₓ, Vₘₐₓ berechnet werden. Dabei wird davon ausgegangen, dass ausgehend von einem bislang gültigen, maximal erlaubten Zählerstand Pₘᵢₙ sich dieser im neuen Zyklus zumindest um eine Mindestgeschwindigkeit Vₘᵢₙ verändert hat. Ebenso wird eine neue Mindestgeschwindigkeit Vₘᵢₙ errechnet, wobei davon ausgegangen wird, dass die bislang gültige und minimal mögliche Geschwindigkeit Vₘᵢₙ sich zumindest um eine maximal erlaubte bzw. mögliche Verzögerungsrate Aₘᵢₙ verringert. Obwohl in der Figur 1 dazu eine Subtraktion ausgeführt wurde, kann bei einer anderen Konvention für das Vorzeichen der minimal erlaubten Beschleunigung bzw. Verzögerung Aₘᵢₙ auch eine Addition verwendet werden; diese Konvention wird in der Figur 2 verwendet. Die Werte für Pₘₐₓ und Vₘₐₓ werden analog zu den bisher diskutierten Variabeln Pₘᵢₙ, Vₘᵢₙ errechnet.

Anschließend wird überprüft, ob die Bedingung der minimalen Beschleunigung verletzt wurde. Da der Inhalt der Zählvariablen P aus technischen Gründen immer ganzzahlig ist, wird der Inhalt dieser Variablen P mit den Vorkommastellen des Integrations-Akkus Pₘᵢₙ verglichen. Dies kann durch eine Trunkierung der Variablen Pₘᵢₙ für den Vergleich realisiert werden. Sofern die Vergleichsbedingung verletzt ist, wird ein unplausibler Zählwert erkannt, was in dem Diagramm nach der Figur 1 zur Ausgabe einer entsprechenden Meldung führt. Selbstverständlich kann jedoch die binäre Information über das Vorliegen eines Fehlers bzw. einer Unplausibilität auch zu beliebigen anderen Reaktionen führen.

Nun wird geprüft, ob ein neuer Zählimpuls eingegangen ist. Dies kann durch Abfrage eines externen Zähler-Registers, eines Interrupt-Registers ("Counting Flag") oder auf andere Weise geschehen. Sofern dies nicht der Fall ist, ist der vorliegende Verarbeitungszyklus des Verfahrens beendet; im Bild der Figur 1 wird "nach oben" verzweigt. Anderenfalls wird der Inkrementalzähler um "1" hochgezählt (inkrementiert) und ein neuer Zeitstempel in der Variablen T gespeichert. Anschließend wird auf Überschreitung des Inkrementalzählers P des erlaubten derzeitigen Maximalwertes Pₘₐₓ geprüft, wobei auch hier wieder eine Trunkierung zum Einsatz kommt. Bei einer Verletzung des Kriteriums wird ebenfalls eine Unplausibilität erkannt und eine entsprechende Meldung abgegeben oder eine andere Maßnahme ergriffen. Insbesondere kann bei einer Unplausibilität eine nachfolgende Verarbeitungsstufe, die das Zählregister P verwendet, benachrichtigt werden. Eine solche Verarbeitungsstufe kann insbesondere eine speicherprogrammierbare Steuerung zur Bewegungssteuerung eines mechanischen Systems, ein Computer oder ähnliches sein.

Anschließend wird geprüft, ob das sog. "Vergleichsfenster" länger als ein Takt gedauert hat. Bei hohen Geschwindigkeiten des mechanischen Systems bzw. bei einer langsamen Zyklusgeschwindigkeit des Überprüfungsalgorithmus kann es zu der folgenden Situation kommen: wenn der gemäß des berechneten Pₘᵢₙ und Pₘₐₓ berechnete Bereich, in dem Zählimpulse als plausibel interpretiert werden, nur einen einzigen FPGA-Takt lang ist, könnte sich die Geschwindigkeit des mechanischen Systems nie ändern, ohne dass ein unplausibler Zählimpuls erkannt werden würde. Denn ein Zählimpuls, der zu genau dem erwarteten FPGA-Takt eintreffen würde, würde wieder zu den gleichen Startwerten für Vₘᵢₙ und Vₘₐₓ führen, welche wiederum zu den gleichen Werten von Pₘᵢₙ und Pₘₐₓ führen würde, die einen plausiblen Zählimpuls wieder nur zu exakt einem FPGA-Takt erlauben. Dieses Problem ist dadurch verursacht, dass bei der Berechnung V=1/(T-Tₐₗₜ) durch den diskreten FPGA-Takt immer eine gewisse Ungenauigkeit entsteht. Deswegen werden, falls eine entsprechende Situation erkannt wird, die Register Vₘᵢₙ, Vₘₐₓ usw. nicht zurückgesetzt, so dass insbesondere deren Nachkommastellen erhalten bleiben, und die beschriebene unerwünschte Situation nicht eintritt. Wenn bei Auslegung des Systems aus den bekannten Systemparametern gefolgert werden kann, dass diese Situation prinzipiell niemals eintreten kann, kann diese zyklische Prüfung natürlich entfallen.

Der zuletzt an unterster Stelle dargestellte Verfahrensschritt dient der Zurücksetzung der Variablen Pₘᵢₙ, Pₘₐₓ, Vmin, Vₘₐₓ, außerdem wird der Zeitstempel des "vorletzten" Zählimpulses, nämlich Tₐₗₜ gespeichert. Damit ist ein Zyklus des erfindungsgemäßen Verfahrens abgearbeitet. Damit steht in jedem Takt der Verarbeitung ein Maximal- und ein Minimalwert (Pₘₐₓ, Pₘᵢₙ) für die Position und damit für die Inhalte des Zählregisters P zur Verfügung, wobei diese Daten für eine Plausibilitätsprüfung jedes einzelnen Zählimpulses genutzt werden können.

In der Figur 2 ist exemplarisch eine Abfolge von 21 Zyklen dargestellt, wobei der Startwert des Inkrementalzählers P mit der Zahl 5000 vorbelegt ist. Es wird davon ausgegangen, dass in diesem Zyklus "Null" ein Impuls erfasst wurde; die Ist-Geschwindigkeit (Taktrate) Vᵢₛₜ ist zu 0,1 vorbelegt, was auch für Vₘₐₓ gilt. Entsprechend ergeben sich in diesem Zyklus als minimal erlaubter Zählerwert Pₘᵢₙ die um Vₘᵢₙ verringerte Zahl, die im Register P zu finden ist, während die maximal erlaubte Position des Zählregisters Pₘₐₓ aus dem Inhalt der Zählvariablen P, vergrößert um die maximal mögliche bzw. erlaubte Geschwindigkeit Vₘₐₓ besteht. In derselben Zeile sind dann auch noch die Trunkierungswerte für Pₘᵢₙ, Pₘₐₓ dargestellt. Zuletzt wird überprüft, ob der Inhalt der Variablen P (hier: 5000) innerhalb des durch die Trunkierungswerte von Pₘᵢₙ, Pₘₐₓ aufgespannten Fensters liegt, was hier aufgrund der Startsituation zwangsläufig der Fall ist, so dass kein Fehler erkannt wird.

Im nächsten Zyklus mit der Nummer 1 ist kein Impuls eingegangen, so dass die Register für Vₘᵢₙ, Vₘₐₓ, Pₘᵢₙ, Pₘₐₓ entsprechend der Rechenvorschrift aus der Figur 1 (mit Ausnahme des geänderten Vorzeichens für Amin) fortgeschrieben (integriert) werden. Dabei ist deutlich zu sehen, dass die erlaubte Minimalgeschwindigkeit sinkt, weil eine von Null verschiedene maximale Verzögerung, nämlich Aₘᵢₙ, als Konstante vorgegeben ist. Entsprechend erhöht sich andererseits auch die maximal erlaubte bzw. mögliche Taktrate bzw. Geschwindigkeit Vₘₐₓ gegenüber dem bisherigen Wert durch die Addition der erlaubten Beschleunigung Aₘₐₓ. Die Ist-Geschwindigkeit bzw. Taktrate Vᵢₛₜ ändert sich hingegen nicht, weil kein neuer Impuls eingegangen ist und somit kein neuer Kehrwert aus dem zeitlichen Abstand der zuletzt eingegangenen Impulse errechnet werden kann. Auch in diesem Zyklus liegt der aktuelle Zählerstand im Rahmen des tolerierten Fensters.

Dies ändert sich erst im Zyklus mit der Nummer 5, in dem ein Impuls eingeht. Erwartet wird jedoch gemäß der trunkierten variablen Pₘₐₓ, dass hier aufgrund der dynamischen Eigenschaften, die vorgegeben sind, noch kein Impuls eingegangen sein kann bzw. darf. Es wird also ein Fehler erkannt. Der neue Impuls hätte erst im nächsten Zyklus mit der Nummer 6 eingegangen sein dürfen, in dem der trunkierte Wert für Pₘₐₓ auf 5001 springt.

Da der zeitliche Abstand zwischen den zuletzt eingegangenen Impulsen fünf Zyklen beträgt, beträgt die errechnete tatsächliche (neue) Geschwindigkeit Vᵢₛₜ nun 0,2. Die Register Vₘᵢₙ, Vₘₐₓ werden auf diesen Wert zurückgesetzt.

Das Verfahren wird jetzt weiter fortgesetzt, wobei der nächste Fehler im Zyklus 14 erkannt wird, weil hier bereits der nächste Zählimpuls hätte eingehen sollen (die Trunkierung von Pₘᵢₙ springt um einen Zähler hoch, der nächste Zählimpuls ist jedoch noch nicht eingegangen).

Leichte Variationen des Verfahrens können sich beispielsweise daraus ergeben, dass in der programmierten Reihenfolge die Berechnung von Mindest- und Maximalwerten für das Zählregister P (Pmin, Pmax) am Anfang oder am Ende eines Verarbeitungszyklus' durchgeführt werden kann; die sich daraus ergebenden Abweichungen sind umso geringer, je höher die Taktrate des Verfahrens im Vergleich zur Taktrate des Zählimpulses ist. Wichtig ist jedoch, dass solange kein neuer Zählimpuls eingeht, die Spanne zwischen den theoretisch möglichen Geschwindigkeiten Vₘᵢₙ, Vₘₐₓ und zwischen dem erlaubten, theoretisch möglichen Zählerstand Pₘᵢₙ, Pₘₐₓ immer größer wird.

Durch das vorstehend beschriebene Verfahren und durch eine entsprechende Auswerteeinrichtung, die insbesondere durch ein FPGA realisiert werden kann, können nicht-plausible Zählimpulse, die beispielsweise aufgrund einer Störung entstehen, erkannt werden. Ebenso können störungsbedingt nicht registrierte Zählimpulse ebenso erkannt werden. Durch die Plausibilitätsprüfung jedes eingehenden Zählimpulses und nicht etwa einer in einem größeren Zeitfenster eingegangenen größeren Anzahl von Zählimpulsen kann die Zuverlässigkeit der Plausibilitätsüberprüfung gegenüber dem Stand der Technik verbessert werden.

## Patentansprüche

1. Verfahren für eine Plausibilitätsprüfung eines Inkrementalzählers,
wobei mittels des Inkrementalzählers Zählimpulse erfassbar sind, und
wobei durch ein dynamisches System die Zählimpulse mit einer zu einem Zustand des dynamischen Systems korrespondierenden Taktrate erzeugt werden,
**dadurch gekennzeichnet,**
**dass** anhand von Betriebsgrenzen des dynamischen Systems ein Minimal- und ein Maximalwert für eine mögliche oder erlaubte Änderung der Taktrate pro Zeiteinheit vorgegeben wird,
**dass** in einem ersten Schritt aus den zwei jeweils zuletzt erfassten Zählimpulsen jeweils eine aktuelle Taktrate errechnet wird, und
**dass** in einem zweiten Schritt bei jedem neu erfassten Zählimpuls dieser dahingehend überprüft wird, ob der Unterschied zwischen der im Zuge des neu erfassten Zählimpulses errechneten Taktrate und einer unmittelbar zuvor errechneten Taktrate innerhalb der durch den Minimal- und Maximalwert definierten Grenzen liegt, wobei anderenfalls eine Unplausibilität erkannt wird.

2. Verfahren nach Patentanspruch 1,
**dadurch gekennzeichnet,**
**dass** in dem ersten Schritt im Falle eines neu erfassten Zählimpulses ein Zeitstempel erfasst wird, wobei aus der Differenz der Zeitstempel der beiden zuletzt erfassten Zählimpulse ein Wert für die aktuelle Taktrate errechnet wird, und
in dem zweiten Schritt aus dem aktuellen Zählerstand des Inkrementalzählers, aus der Differenz zwischen einer aktuellen Zeit und dem zuletzt erfassten Zeitstempel, aus dem ermittelten Wert für die Taktrate, und aus dem Minimal- und Maximalwert für die mögliche oder erlaubte Änderung der Taktrate pro Zeiteinheit ein Wertebereich für einen bezogen auf die jeweils aktuelle Zeit jeweils erlaubten aktuellen Zählerstand aktualisiert wird, wonach der jeweils aktuelle Zählerstand mit dem Wertebereich verglichen wird, wobei in dem Falle, in dem der jeweils aktuelle Zählerstand nicht in dem Wertebereich liegt, eine Unplausibilität festgestellt und/oder gemeldet wird.

3. Verfahren nach Patentanspruch 1 oder 2,
**dadurch gekennzeichnet,**
**dass** die Plausibilitätsprüfung in dem zweiten Schritt einen Vergleich der jeweils ermittelten Wert für die aktuelle Taktrate mit einem anhand von Betriebsgrenzen des dynamischen Systems vorgegebenen weiteren Minimalund einem weiteren Maximalwert für eine mögliche oder erlaubte minimale und maximale Taktrate pro Zeiteinheit vornimmt.

4. Verfahren nach einem der Patentansprüche 2 oder 3,
**dadurch gekennzeichnet,**
**dass** der Wertebereich für den bezogen auf die jeweils aktuelle Zeit jeweils erlaubten aktuellen Zählerstand durch den Inhalt jeweils einer Variable für einen minimal erlaubten Zählerstand und einen maximal erlaubten Zählerstand festgelegt ist, wobei
in dem zweiten Schritt die Aktualisierung des Wertebereich durch Addieren des mit der seit der letzten Aktualisierung vergangenen Zeit multiplizierten Minimal- bzw. Maximalwertes zu dem jeweiligen bisherigen Inhalts der Variablen erfolgt.

5. Verfahren nach Patentanspruch 4,
**dadurch gekennzeichnet,**
**dass** die Inhalte der Variablen mit Erfassung eines neuen und als plausibel erkannten Zählimpulses auf den aktuellen Zählerstand zurückgesetzt werden.

6. Verfahren nach einem der vorhergehenden Patentansprüche,
**dadurch gekennzeichnet,**
**dass** die Verfahrensschritte zyklisch wiederholt durchgeführt werden.

7. Verfahren nach Patentanspruch 6,
**dadurch gekennzeichnet,**
**dass** mit jedem Zyklus ein Zykluszähler inkrementiert wird, wobei der Zyklenzähler als Zeitbasis für die Errechnung der Taktrate verwendet wird.

8. Auswerteeinrichtung für eine Plausibilitätsprüfung eines Inkrementalzählers,
wobei mittels des Inkrementalzählers Zählimpulse erfassbar sind,
wobei durch ein dynamisches System die Zählimpulse mit einer zu einem Zustand des dynamischen Systems korrespondierenden Taktrate erzeugt werden,
**dadurch gekennzeichnet,**
**dass** anhand von Betriebsgrenzen des dynamischen Systems ein Minimal- und ein Maximalwert für eine mögliche oder erlaubte Änderung der Taktrate pro Zeiteinheit vorgegeben wird,
wobei die Auswerteeinrichtung derart eingerichtet ist, dass in einem ersten Schritt aus den zwei jeweils zuletzt erfassten Zählimpulsen jeweils eine aktuelle Taktrate errechnet wird, und
**dass** in einem zweiten Schritt bei jedem neu erfassten Zählimpuls dieser dahingehend überprüft wird, ob der Unterschied zwischen der im Zuge des neu erfassten Zählimpulses errechneten Taktrate und einer unmittelbar zuvor errechneten Taktrate innerhalb der durch den Minimal- und Maximalwert definierten Grenzen liegt, wobei anderenfalls eine Unplausibilität erkannt wird.

9. Auswerteeinrichtung nach Patentanspruch 8,
**dadurch gekennzeichnet,**
**dass** die Auswerteeinrichtung derart ausgestaltet ist, dass in dem ersten Schritt im Falle eines neu erfassten Zählimpulses ein Zeitstempel erfasst wird, wobei aus der Differenz der Zeitstempel der beiden zuletzt erfassten Zählimpulse ein Wert für die aktuelle Taktrate errechnet wird, und
in dem zweiten Schritt aus dem aktuellen Zählerstand des Inkrementalzählers, aus der Differenz zwischen einer aktuellen Zeit und dem zuletzt erfassten Zeitstempel, aus dem ermittelten Wert für die Taktrate, und aus dem Minimal- und Maximalwert für die mögliche oder erlaubte Änderung der Taktrate pro Zeiteinheit ein Wertebereich für einen bezogen auf die jeweils aktuelle Zeit jeweils erlaubten aktuellen Zählerstand aktualisiert wird, wonach der jeweils aktuelle Zählerstand mit dem Wertebereich verglichen wird, wobei in dem Falle, in dem der jeweils aktuelle Zählerstand nicht in dem Wertebereich liegt, eine Unplausibilität festgestellt und/oder gemeldet wird.

10. Auswerteeinrichtung nach Patentanspruch 8 oder 9,
**dadurch gekennzeichnet,**
**dass** die Auswerteeinrichtung derart eingerichtet ist, dass die Plausibilitätsprüfung in dem zweiten Schritt einen Vergleich der jeweils ermittelten Wert für die aktuelle Taktrate mit einem anhand von Betriebsgrenzen des dynamischen Systems vorgegebenen weiteren Minimalund einem weiteren Maximalwert für eine mögliche oder erlaubte minimale und maximale Taktrate pro Zeiteinheit vornimmt.

11. Auswerteeinrichtung nach einem der Patentansprüche 8 bis 10,
**dadurch gekennzeichnet,**
**dass** der Wertebereich für den bezogen auf die jeweils aktuelle Zeit jeweils erlaubten aktuellen Zählerstand durch den Inhalt jeweils einer Variable für einen minimal erlaubten Zählerstand und einen maximal erlaubten Zählerstand festgelegt ist,
wobei die Auswerteeinrichtung derart ausgestaltet ist, dass in dem zweiten Schritt die Aktualisierung des Wertebereich durch Addieren des mit der seit der letzten Aktualisierung vergangenen Zeit multiplizierten Minimal- bzw. Maximalwertes zu dem jeweiligen bisherigen Inhalts der Variablen erfolgt.

12. Auswerteeinrichtung nach einem der Patentansprüche 8 bis 11,
**dadurch gekennzeichnet,**
**dass** die Auswerteeinrichtung derart ausgestaltet ist, dass die Inhalte der Variablen mit Erfassung eines neuen und als plausibel erkannten Zählimpulses auf den aktuellen Zählerstand zurückgesetzt werden.

13. Auswerteeinrichtung nach einem der Patentansprüche 8 bis 12,
**dadurch gekennzeichnet,**
**dass** die Auswerteeinrichtung zur zyklischen Wiederholung der Verfahrensschritte eingerichtet ist.

14. Auswerteeinrichtung nach einem der Patentansprüche 8 bis 13,
**dadurch gekennzeichnet,**
**dass** in der Auswerteeinrichtung ein mit jedem Zyklus zu inkrementierender Zykluszähler definiert ist, wobei der Zyklenzähler als Zeitbasis für die Errechnung der Taktrate verwendbar ist.

15. Auswerteeinrichtung nach einem der Patentansprüche 8 bis 14,
**dadurch gekennzeichnet,**
**dass** die Auswerteeinrichtung im Wesentlichen aus einem programmierbaren Logikbaustein gebildet ist, wobei die zur Plausibilitätsprüfung auszuführenden Berechnungen mittels eines Logikprogramms definiert sind.

## Claims

1. Method for checking the plausibility of an incremental counter,
wherein counting pulses can be detected by means of the incremental counter, and
wherein a dynamic system generates the counting pulses with a clock rate corresponding to a state of the dynamic system,
**characterized**
**in that** a minimum value and a maximum value for a possible or permitted change in the clock rate per time unit is predefined on the basis of operating limits of the dynamic system,
**in that**, in a first step, a current clock rate is calculated in each case from the two counting pulses respectively detected last, and
**in that**, in a second step, at each newly detected counting pulse said counting pulse is checked to determine if the difference between the clock rate calculated in the course of the newly detected counting pulse and a clock rate calculated immediately beforehand is within the limits defined by the minimum value and maximum value, wherein otherwise implausibility is detected.

2. Method according to Patent Claim 1,
**characterized**
**in that**, in the first step, in the case of a newly detected counting pulse a timestamp is detected, wherein a value for the current clock rate is calculated from the difference between the timestamps of the two counting pulses detected last, and,
in the second step, a value range for a current counter reading which is permitted in each case with respect to the respective current time is updated on the basis of the current counter reading of the incremental counter, on the basis of the difference between a current time and the timestamp detected last, on the basis of the determined value for the clock rate and on the basis of the minimum value and maximum value for the possible or permitted change in the clock rate per time unit, after which the respective current counter reading is compared with the value range, wherein in the event of the respective current counter reading not being in the value range, implausibility is detected and/or signaled.

3. Method according to Patent Claim 1 or 2,
**characterized**
**in that** the plausibility checking in the second step performs a comparison of the respectively determined value for the current clock rate with a further minimum value and a further maximum value, predefined on the basis of operating limits of the dynamic system, for a possible or permitted minimum and maximum clock rate per time unit.

4. Method according to either of Patent Claims 2 and 3,
**characterized**
**in that** the value range for the current counter reading which is permitted in each case with respect to the respective current time is defined by the content of, in each case, one variable for a minimum permitted counter reading and a maximum permitted counter reading, wherein, in the second step, the updating of the value range is carried out by adding the minimum or maximum value multiplied by the time which has passed since the last update to the respective previous content of the variable.

5. Method according to Patent Claim 4,
**characterized**
**in that** the contents of the variable are reset to the current counter reading with the detection of a new counting pulse which is detected as plausible.

6. Method according to one of the preceding patent claims,
**characterized**
**in that** the method steps are carried out in a cyclically repeating fashion.

7. Method according to Patent Claim 6,
**characterized**
**in that** a cycle counter is incremented with each cycle, wherein the cycle counter is used as a time base for the calculation of the clock rate.

8. Evaluation device for checking the plausibility of an incremental counter,
wherein counting pulses can be detected by means of the incremental counter,
wherein a dynamic system generates the counting pulses with a clock rate corresponding to a state of the dynamic system,
**characterized**
**in that** a minimum value and a maximum value for a possible or permitted change in the clock rate per time unit is predefined on the basis of operating limits,
wherein the evaluation device is configured in such a way that, in a first step, a current clock rate is calculated in each case from the two counting pulses respectively detected last, and
that, in a second step, at each newly detected counting pulse said counting pulse is checked to determine if the difference between the clock rate calculated in the course of the newly detected counting pulse and a clock rate calculated immediately beforehand is within the limits defined by the minimum value and maximum value, wherein otherwise implausibility is detected.

9. Evaluation device according to Patent Claim 8,
**characterized**
**in that** the evaluation device is configured in such a way that, in the first step, in the case of a newly detected counting pulse a timestamp is detected, wherein a value for the current clock rate is calculated from the difference between the timestamps of the two counting pulses detected last, and,
in the second step, a value range for a current counter reading which is permitted in each case with respect to the respective current time is updated on the basis of the current counter reading of the incremental counter, on the basis of the difference between a current time and the timestamp detected last, on the basis of the determined value for the clock rate and on the basis of the minimum value and maximum value for the possible or permitted change in the clock rate per time unit, after which the respective current counter reading is compared with the value range, wherein in the event of the respective current counter reading not being in the value range, implausibility is detected and/or signaled.

10. Evaluation device according to Patent Claim 8 or 9,
**characterized**
**in that** the evaluation device is configured in such a way that the plausibility checking in the second step performs a comparison of the respectively determined value for the current clock rate with a further minimum value and a further maximum value, predefined on the basis of operating limits of the dynamic system, for a possible or permitted minimum and maximum clock rate per time unit.

11. Evaluation device according to one of Patent Claims 8 to 10,
**characterized**
**in that** the value range for the current counter reading which is permitted in each case with respect to the respective current time is defined by the content of, in each case, one variable for a minimum permitted counter reading and a maximum permitted counter reading, wherein the evaluation device is configured in such a way that, in the second step, the updating of the value range is carried out by adding the minimum or maximum value multiplied by the time which has passed since the last update to the respective previous content of the variable.

12. Evaluation device according to one of Patent Claims 8 to 11,
**characterized**
**in that** the evaluation device is configured in such a way that the contents of the variable are reset to the current counter reading with the detection of a new counting pulse which is detected as plausible.

13. Evaluation device according to one of Patent Claims 8 to 12,
**characterized**
**in that** the evaluation device is configured to repeat the method steps cyclically.

14. Evaluation device according to one of Patent Claims 8 to 13,
**characterized**
**in that** in the evaluation device a cycle counter which is to be incremented with each cycle is defined, wherein the cycle counter can be used as a time base for the calculation of the clock rate.

15. Evaluation device according to one of Patent Claims 8 to 14,
**characterized**
**in that** the evaluation device is formed essentially from a programmable logic module, wherein the calculations which are to be carried out for the plausibility checking are defined by means of a logic program.

## Revendications

1. Procédé de contrôle de vraisemblance d'un compteur incrémental,
dans lequel des impulsions de comptage peuvent être détectées au moyen du compteur incrémental et
dans lequel on produit par un système dynamique les impulsions de comptage à une cadence correspondant à un état du système dynamique,
**caractérisé**
**en ce que**, à l'aide de limites du fonctionnement du système dynamique, on donne à l'avance par unité de temps une valeur minimum et une valeur maximum d'une variation possible ou permise de la cadence,
**en ce que**, dans un premier stade, on calcule respectivement une cadence présente à partir des deux impulsions de comptable détectées en dernier et
**en ce que**, dans un deuxième stade, on contrôle, à chaque impulsion de comptage détectée à nouveau pour celle-ci, si la différence entre la cadence calculée au cours de l'impulsion de comptage détectée à nouveau et une cadence détectée immédiatement avant se trouve dans les limites définies par la valeur minimum et la valeur maximum, en reconnaissant sinon un manque de vraisemblance.

2. Procédé suivant la revendication 1,
**caractérisé**
**en ce que**, dans le premier stade, on détecte un horodatage, dans le cas d'une impulsion de contact détectée à nouveau,
en calculant une valeur de la cadence présente à partir de la différence de l'horodatage des deux impulsions de contact détectées en dernier et
dans le deuxième stade, à partir de l'état présent du compteur incrémental, on met à jour, à partir de la différence entre un temps présent et l'horodatage détecté en dernier, à partir de la valeur déterminée pour la cadence et à partir de la valeur minimum et de la valeur maximum pour la variation possible ou permise de la cadence par unité de temps, une plage de valeurs pour un état du compteur présent permis rapporté au temps présent, en comparant l'état présent du compteur à la plage de valeurs, dans lequel, dans le cas où l'état présent du compteur ne se trouve pas dans la plage de valeurs, on constate et/ou annonce un manque de vraisemblance.

3. Procédé suivant la revendication 1 ou 2,
**caractérisé**
**en ce que** le contrôle de vraisemblance effectue, par unité de temps, dans le deuxième stade, une comparaison de la valeur déterminée de la cadence présente à une autre valeur minimum et à une autre valeur maximum d'une cadence minimum possible ou maximum possible ou permise, données à l'avance à l'aide de limite de fonctionnement du système dynamique.

4. Procédé suivant l'une des revendications 2 ou 3,
**caractérisé**
**en ce que** la plage de valeurs de l'état du compteur présent permis rapporté au temps actuel est fixée par le contenu d'une variable d'un état minimum permis du compteur et d'un état maximum permis du compteur, dans lequel dans le deuxième stade, on effectue la mise à jour de la plage de valeurs en additionnant la valeur minimum ou maximum, multipliée par le temps écoulé depuis la dernière mise à jour, au contenu jusqu'ici des variables.

5. Procédé suivant la revendication 4,
**caractérisé**
**en ce qu'**on remet les contenus des variables sur l'état présent du compteur par une détection d'une impulsion de comptage nouvelle et reconnue comme vraisemblable.

6. Procédé suivant l'une des revendications précédentes,
**caractérisé**
**en ce qu'**on effectue les stades du procédé d'une manière répétée cycliquement.

7. Procédé suivant la revendication 6,
**caractérisé**
**en ce que**, à chaque cycle, on incrémente un compteur cyclique, le compteur cyclique étant utilisé comme base de temps pour le calcul de la cadence.

8. Dispositif d'évaluation d'un contrôle de vraisemblance d'un compteur incrémental,
dans lequel des impulsions de comptage peuvent être détectées à l'aide du compteur incrémental,
dans lequel on produit, par un système dynamique, des impulsions de comptage à une cadence correspondant à un état du système dynamique,
**caractérisé**
**en ce que**, à l'aide de limites du fonctionnement du système dynamique, on donne à l'avance par unité de temps une valeur minimum et une valeur maximum d'une variation possible ou permise de la cadence,
dans lequel le dispositif d'évaluation est agencé de manière à calculer, dans un premier stade, une cadence présente à partir des deux impulsions de comptage détectées en dernier et
**en ce que**, dans un deuxième stade, on contrôle, à chaque impulsion de comptage détectée à nouveau pour celle-ci, si la différence entre la cadence calculée au cours de l'impulsion de comptage détectée à nouveau et une cadence détectée immédiatement avant se trouve dans les limites définies par la valeur minimum et la valeur maximum, en reconnaissant sinon un manque de vraisemblance.

9. Dispositif d'évaluation suivant la revendication 8,
**caractérisé**
**en ce que** le dispositif d'évaluation est conformé de manière à ce que
dans le premier stade, on détecte un horodatage, dans le cas d'une impulsion de contact détectée à nouveau, en calculant une valeur de la cadence présente à partir de la différence de l'horodatage des deux impulsions de contact détectées en dernier et
dans le deuxième stade, à partir de l'état présent du compteur incrémental, on met à jour, à partir de la différence entre un temps présent et l'horodatage détecté en dernier, à partir de la valeur déterminée pour la cadence et à partir de la valeur minimum et de la valeur maximum pour la variation possible ou permise de la cadence par unité de temps, une plage de valeurs pour un état du compteur présent permis rapporté au temps présent, en comparant l'état présent du compteur à la plage de valeurs, dans lequel, dans le cas où l'état présent du compteur ne se trouve pas dans la plage de valeurs, on constate et/ou annonce un manque de vraisemblance.

10. Dispositif d'évaluation suivant la revendication 8 ou 9,
**caractérisé**
**en ce que** le dispositif d'évaluation est agencé de manière à ce que le contrôle de vraisemblance effectue, par unité de temps, dans le deuxième stade, une comparaison de la valeur déterminée de la cadence présente à une autre valeur minimum et à une autre valeur maximum, d'une cadence minimum possible ou maximum possible ou permise, données à l'avance à l'aide de limites de fonctionnement du système dynamique.

11. Dispositif d'évaluation suivant l'une des revendications 8 à 10,
**caractérisé**
**en ce que** la plage de valeurs de l'état du compteur présent permis rapporté au temps actuel est fixée par le contenu d'une variable d'un état minimum permis du compteur et d'un état maximum permis du compteur,
dans lequel le dispositif d'évaluation est conformé de manière à ce que, dans le deuxième stade, on effectue la mise à jour de la plage de valeurs en additionnant la valeur minimum ou la valeur maximum, multipliée par le temps écoulé depuis la dernière mise à jour, au contenu jusqu'ici des variables.

12. Dispositif d'évaluation suivant l'une des revendications 8 à 11
**caractérisé**
**en ce que** le dispositif d'évaluation est conformé de manière à ce qu'on remet les contenus des variables à l'état présent du compteur par une détection d'une impulsion de comptage nouvelle et reconnue comme vraisemblable.

13. Dispositif d'évaluation suivant l'une des revendications 8 à 12,
**caractérisé**
**en ce que** le dispositif d'évaluation est agencé pour la répétition cyclique des stades du procédé.

14. Dispositif d'évaluation suivant l'une des revendications 8 à 13,
**caractérisé**
**en ce qu'**il est défini, dans le dispositif d'évaluation, un compteur cyclique à incrémenter à chaque cycle, le compteur cyclique pouvant être utilisé comme base de temps pour le calcul de la cadence.

15. Dispositif d'évaluation suivant l'une des revendications 8 à 14,
**caractérisé**
**en ce que** le dispositif d'évaluation est formé essentiellement d'un module logique programmable, les calculs exécutant le contrôle de vraisemblance étant définis au moyen d'un programme logique.
